# EUROPÄISCHE PATENTANMELDUNG

(11) **EP 1 538 453 A1**
(43) Veröffentlichungstag der Anmeldung: **08.06.2005**
(21) Anmeldenummer: 03027733.9
(22) Anmeldetag: 02.12.2003
(51) Int. Cl.: G01R 31/3173, G01R 31/02

(54) **Vorrichtung und Verfahren zur Fehlerdiagnose an digitalen Ausgängen einer Steuerbaugruppe**

(71) Anmelder: SIEMENS AKTIENGESELLSCHAFT, 80333 München (DE)
(72) Erfinder: Glöckner, Knut, 09113 Chemnitz (DE); Röhle, Holger, 09235 Burkhardtsdorf (DE); Slanina, Michael, 09130 Chemnitz (DE)

(57) **Zusammenfassung**

Die Erfindung betrifft eine Vorrichtung zur Fehlerdiagnose an digitalen Ausgängen (D1) einer Steuerbaugruppe (IC1), insbesondere der Erkennung eines Drahtbruchs zwischen einem elektrischen Anschluss (K11) an einem der digitalen Ausgänge (D1) der Steuerbaugruppe (IC1) und einer an dem elektrischen Anschluss (K11) anschließbaren Last (L), wobei eine Spannungsbegrenzerbaugruppe (V1) und eine Auswertebaugruppe (A) so mit dem elektrischen Anschluss (K11) verbunden sind, dass bei Drahtbruch zwischen dem elektrischen Anschluss (K11) und der Last (L), an der Auswertebaugruppe (A) ein von der Spannungsbegrenzerbaugruppe (V1) mitbestimmter Spannungswert (U1a) anliegt, wenn der digitale Ausgang (D1) einen ersten Zustand "digital Null" aufweist.

## Beschreibung

Vorrichtung und Verfahren zur Fehlerdiagnose an digitalen Ausgängen einer Steuerbaugruppe

Die vorliegende Erfindung betrifft eine Vorrichtung und ein Verfahren zur Fehlerdiagnose an digitalen Ausgängen einer Steuerbaugruppe. Insbesondere betrifft die vorliegende Erfindung eine Vorrichtung und ein Verfahren zum Erkennen eines Drahtbruchs zwischen einem elektrischen Anschluss an einem digitalen Ausgang der Steuerbaugruppe und einer daran angeschlossenen Last.

Steuerbaugruppen mit digitalen Ausgängen sind bereits heute in vielen Varianten bekannt. Ein digitaler Ausgang kann dabei einen der beiden digitalen Zustände "digital EINS" oder "digital NULL" aufweisen. Je nach Zustand des digitalen Ausgangs wird eine daran angeschlossene Last von der Steuerbaugruppe gesteuert.

In Automatisierungssystemen werden solche Steuerbaugruppen unter anderem dazu benutzt, um verschiedenste Aktoren, wie beispielsweise elektromagnetische Bauelemente, und insbesondere auch Signalgeber, anzusteuern. Diese Aktoren weisen einen bestimmten Lastwiderstand auf und werden gegebenenfalls zusammen mit einem Vorwiderstand zur Strombegrenzung über den entsprechenden elektrischen Anschluss mit einem der digitalen Ausgänge der Steuerbaugruppe verbunden.

Werden solche Signalgeber beispielsweise zu Überwachungszwecken in Automatisierungssystemen eingesetzt, so wird der digitale Ausgang je nach Betriebszustand einen der beiden digitalen Zustände aufweisen. So wird beispielsweise bei einem Feuermelder im normalen Betrieb des Automatisierungssystems der Ausgang der Steuerbaugruppe den Zustand "digital NULL" aufweisen, während im Störungsfall der Zustand "digital EINS" am Ausgang vorliegt und damit der Signalgeber aktiviert ist.

Tritt nun zwischen dem elektrischen Anschluss und dem Signalgeber eine Unterbrechung aufgrund eines Drahtbruches auf, kann der Aktor nicht mehr von der Steuerbaugruppe gesteuert werden und es kommt zu einer Fehlfunktion im Störungsfall des Automatisierungssystems. Gerade dann, wenn wie im Falle des Signalgebers als Feuermelder, der Zustand "digital NULL" dem normalen Betriebszustand entspricht und der Zustand "digital EINS" nur sehr selten auftritt, wird solch eine Fehlfunktion ohne eine zusätzliche Überwachung über eine längere Zeitdauer nicht erkannt. Um diesen Fehlfunktionsfall rechtzeitig festzustellen, wäre es denkbar, in regelmäßigen Abständen ein zusätzliches Testsignal an den elektrischen Anschluss anzulegen, um damit zu testen, ob die Last noch sicher an dem elektrischen Anschluss angeschlossen ist.

Aufgabe der vorliegenden Erfindung ist es, eine Vorrichtung und ein Verfahren zur Fehlerdiagnose an digitalen Ausgängen einer Steuerbaugruppe anzugeben, mit der auf einfache Art und Weise insbesondere ein Kabelbruch zwischen einem elektrischen Anschluss an einem digitalen Ausgang einer Steuerbaugruppe und der daran angeschlossenen Last bei Zustand "digital NULL", erkannt werden kann.

Diese Aufgabe wird gelöst durch die Vorrichtung mit den Merkmalen des Anspruchs 1, sowie durch das Verfahren mit den Merkmalen des Anspruchs 8.

Indem eine Spannungsbegrenzerbaugruppe und eine Auswertebaugruppe so mit dem elektrischen Anschluss eines digitalen Ausgangs verbunden sind, dass bei Drahtbruch, zwischen dem elektrischen Anschluss und der daran angeschlossenen Last, an der Auswertebaugruppe ein von der Spannungsbegrenzerbaugruppe mitbestimmter Spannungswert anliegt, wenn der digitale Ausgang einen ersten Zustand "digital Null" aufweist, kann dieser Spannungswert dann in der Auswertebaugruppe mit einem Referenzspannungswert verglichen und damit ein Drahtbruch erkannt, diagnostiziert und gemeldet werden. Sowohl die erfindungsgemäße Vorrichtung als auch das erfindungsgemäße Verfahren können somit zur Erkennung eines Kabelbruchs benutzt werden, auch ohne dass dafür ein zusätzliches Testsignal notwendig ist. Die vorliegende Erfindung ermöglicht somit auf einfachste Art und Weise die Fehlerdiagnose an digitalen Ausgängen von Steuerbaugruppen.

Weitere vorteilhafte Ausführungen und bevorzugte Weiterbildungen der Erfindung sind den Unteransprüchen zu entnehmen.

Die Erfindung sowie vorteilhafte Ausführungen derselben werden im Weiteren beispielhaft anhand der nachfolgenden Figuren beschrieben. Es zeigen:
- Fig.1: den prinzipiellen Aufbau der erfindungsgemäßen Vorrichtung,
- Fig.2: ein erstes Beispiel einer Schaltungsanordnung zum Durchführen des erfindungsgemäßen Verfahrens,
- Fig.3: ein zweites Beispiel einer Schaltungsanordnung zum Durchführen des erfindungsgemäßen Verfahrens.

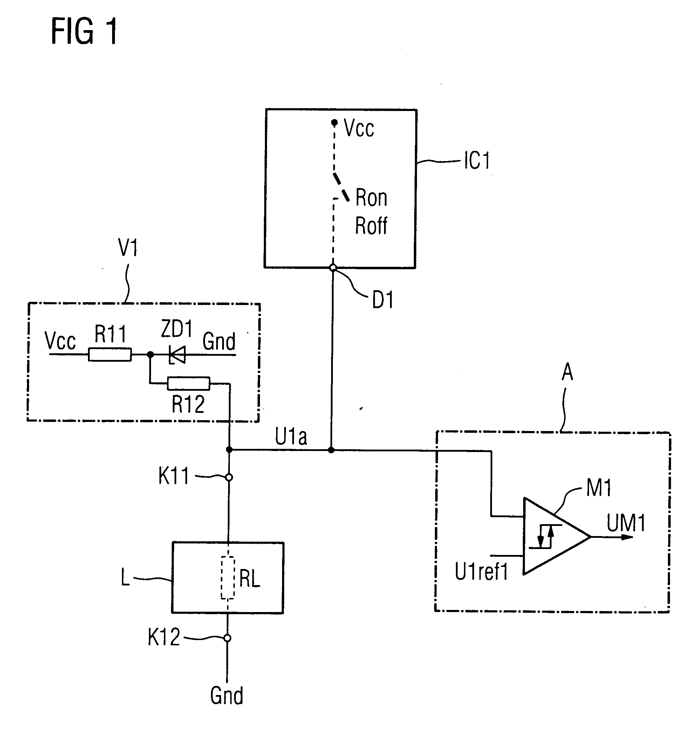

In Figur 1 ist der Zustand des digitalen Ausgangs D1 der Steuerbaugruppe IC1 durch den mit der Spannung Vcc verbundenen Schalter dargestellt, wobei ein geschlossener Schalter den Zustand "digital EINS" und ein offener Schalter den Zustand "digital Null" des digitalen Ausgangs D1 anzeigen soll. Im Ersatzschaltbild für diesen Schalter ist der digitale Ausgang D1 im Zustand "digital EINS" über einen Widerstand Ron und im Zustand "digital NULL" über einen Widerstand Roff mit der Versorgungsspannung Vcc verbunden, wobei Ron viel kleiner als Roff ist. Am digitalen Ausgang D1 der Steuerbaugruppe IC1 befindet sich ein elektrischer Anschluss K11, der zum Beispiel als Klemme ausgebildet ist und an den die von der Steuerbaugruppe IC1 zu steuernde Last L angeschlossen ist. Diese Last L kann durch einen Lastwiderstand RL, der, so wie hier dargestellt, eine rein ohmsche Last ist, in aller Regel aber auch induktive und kapazitive Anteile besitzen wird, nachgebildet werden. Die Last L, welche beispielsweise ein Signalgeber als Aktor sein kann, ist also auf der einen Seite mit dem elektrischen Anschluss K11 mit dem digitalen Ausgang D und auf der anderen Seite über einen weiteren elektrischen Anschluss K12 mit der Masse Gnd verbunden. Erfindungsgemäß sind nun zwischen dem digitalen Ausgang D und dem elektrischen Anschluss K11 eine Spannungsbegrenzerbaugruppe V1 und eine Auswerteeinheit A angeschlossen. Die Spannungsbegrenzerbaugruppe V1 ist dabei vorzugsweise als Spannungsteiler, aus einem ersten Widerstand R11 und einer Zenerdiode ZD1 zwischen Versorgungsspannung Vcc und Masse Gnd besteht, ausgebildet. Über einen zweiten Widerstand R12 ist dieser Spannungsteiler mit dem digitalen Ausgang D1 und dem elektrischen Anschluss K11 verbunden. Die Zenerdiode ZD1 bewirkt, dass je nach der durch sie vorgegebenen Zenerspannung ein bestimmter Spannungswert am Knoten zwischen R11, R12 und ZD1 anliegt. Die Auswerteeinheit A dient dazu, den am Knoten zwischen dem digitalen Ausgang D1 und dem elektrischen Anschluss K11 anliegenden Spannungswert U1a zu messen und mit einer Referenzspannung U1ref1 zu vergleichen. Kommt es nun im Zustand "digital Null" des digitalen Ausgangs D1 zu einem Kabelbruch oder einer anderen Art der Unterbrechung zwischen den elektrischen Anschlüssen K11 und K12, wird über den zweiten Widerstand R12 der Strombegrenzerschaltung V1 eine Spannung an diesen Knoten eingeprägt, so dass zwischen digitalem Ausgang D1 und elektrischem Anschluss K11 und damit auch an der Auswerteeinheit A ein Spannungswert U1a anliegt, der im Wesentlichen von der Zenerspannung der Zenerdiode ZD1 der Spannungsbegrenzerbaugruppe V bestimmt ist. Ein Komparator M1 in der Auswerteeinheit A vergleicht diesen Spannungswert U1a mit dem voreingestellten ersten Spannungsreferenzwert U1ref1. Ist der Spannungswert U1a größer oder gleich dem Spannungsreferenzwert U1ref1, wird sich das Signal UM1 am Ausgang des Komparators M1 ändern und damit auf einen vorliegenden Kabelbruch hinweisen.

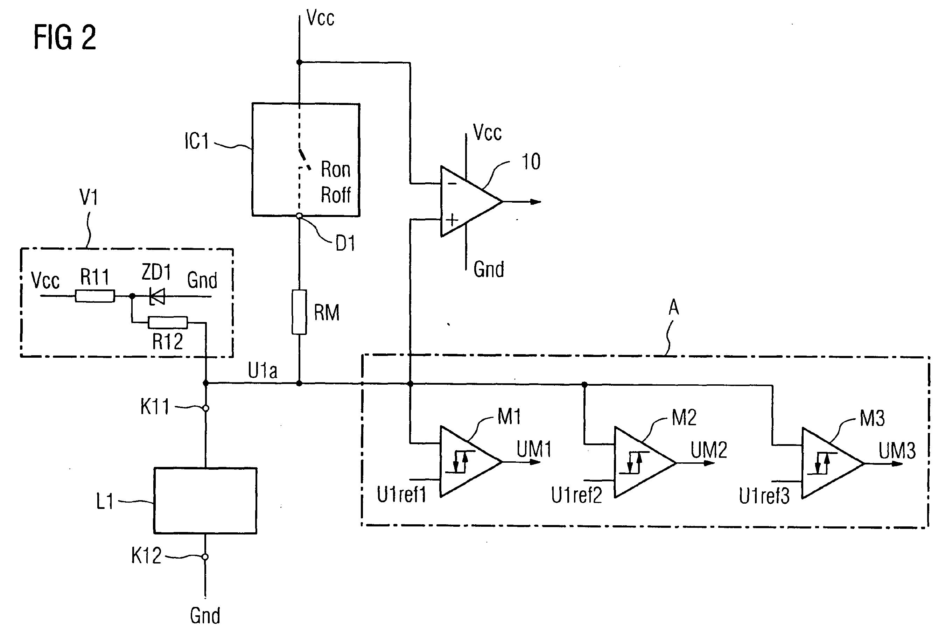

Figur 2 zeigt beispielhaft eine mögliche Ausführungsform einer Schaltungsanordnung zum Durchführen des erfindungsgemäßen Verfahrens. Zudem ist hier die entsprechende Dimensionierung der einzelnen Bauelemente der Baugruppen V und A für eine Steuerbaugruppe IC1 des Typs BTS 4141D mit einer Versorgungsspannung von Vcc=24V dargestellt. Der am digitalen Ausgang D1 anschließbare Aktor L1 sollte dabei einen Widerstandswert im Bereich von 47 Ohm bis 4K Ohm und eine Induktivität bis 1,1 Henry aufweisen. Die in Figur 2 dargestellte Schaltungsanordnung ist dabei so ausgelegt, dass neben dem Kabelbruch auch noch weitere mögliche Fehlerzustände, insbesondere Kurzschluss gegen Versorgungsspannung Vcc und gegen Masse Gnd zwischen elektrischen Anschluss K11 und Last L1, erkannt und diagnostiziert werden können. Dazu weist die Auswerteeinheit A drei Komparatoren M1, M2 und M3 auf. Die Spannungsbegrenzerbaugruppe V1 weist, wie bereits in Figur 1 gezeigt, eine Zenerdiode ZD1, einen ersten (R11) und einen zweiten (R12) Widerstand auf. Die Zenerdiode ZD1 ist so ausgelegt, dass an ihr eine Zenerspannung von 8,2V auftreten kann. Kommt es nun zwischen der Last L1 und dem elektrischen Anschluss K11, oder auch zwischen der Last L1 und einer weiteren Klemme K12, die die Last L1 mit Masse Gnd verbindet, im Zustand "digital Null" des digitalen Ausgangs D1 zu einem Kabelbruch, so wird sich zwischen dem elektrischem Anschluss K11 und dem digitalem Ausgang D1 ein Spannungswert U1a einstellen, der durch die Zenerspannung von 8,2V und dem Spannungsabfall über den zweiten Widerstand R12 bestimmt ist. Dieser Spannungswert U1a wird im vorliegenden Beispiel in der Auswertebaugruppe A mittels des Komparators M1 vom Typ LM2901 mit einem voreingestellten Referenzspannungswert von U1ref1=5V verglichen. Da der Spannungswert U1a größer als der Referenzspannungswert U1ref1 ist, wird vom Komparator K1 ein Ausgangssignal UM1 erzeugt, das den Fehlerzustand Kabelbruch signalisiert, womit dann der Kabelbruch erkannt und diagnostiziert werden kann.

In dem in Figur 2 gezeigten Ausführungsbeispiel sind die beiden anderen Komparatoren M2 und M3 vorgesehen, um auch die Fehlerzustände Kurzschluss gegen Masse (Gnd) und gegen Versorgungsspannung (Vcc) detektieren und damit diagnostizieren zu können. Im Fehlerfall Kurzschluss gegen Masse wird zwischen digitalem Ausgang D1 und dem elektrischen Anschluss K11 nun ein Spannungswert U1a von nur wenigen Millivolt (ca. 5mV) vorliegen. Dieser Spannungswert U1a wird in der Auswerteeinheit A vom Komparator M2 mit einem voreingestellten Referenzspannungswert von U1ref2=11mV verglichen. Wenn der Spannungswert U1a kleiner als dieser Referenzspannungswert U1ref2 ist, wird vom Komparator M2 ein Ausgangsignal UM2 erzeugt, dass den Fehlerzustand Kurzschluss gegen Masse signalisiert. Entsprechend wird im Fehlerfall Kurzschluss gegen Versorgungsspannung Vcc zwischen dem digitalen Ausgang D1 und dem elektrischen Anschluss K11 ein Spannungswert U1a anliegen, der nahezu dem Wert der Versorgungsspannung von Vcc=24V entspricht. Dieser Spannungswert wird in der Auswertebaugruppe A von einem Komparator M3 mit einem voreingestellten Referenzspannungswert von Ulref3= 15V vergleichen. Da in diesem Falle der Spannungswert U1a größer als der Referenzspannungswert U1ref3 ist, wird vom Komparator M3 ein Ausgangssignal UM3 erzeugt, das den Fehlerzustand Kurzschluss gegen Versorgungsspannung signalisiert. Der Vollständigkeit halber sei noch darauf hingewiesen, dass mit den Komparatoren M1 bis M3, und den in Figur 2 dargestellten zusätzlichen Bauelementen, das heißt dem Messwiderstand RM und dem Operationsverstärker 10, auch die Fehlerzustände für den Fall ermittelt werden können, wenn der digitale Ausgang D1 den Zustand "digital EINS" aufweist. Somit bietet die in Figur 2 gezeigte Schaltungsanordnung die Möglichkeit, alle möglichen Fehlerfälle bezüglich Kurzschluss und Kabelbruch bei der Anbindung einer Last L1 an die elektrischen Anschlüsse K11 und K12 und für beide digitalen Zustände am digitalen Ausgang D1 zu erkennen und zu diagnostizieren.

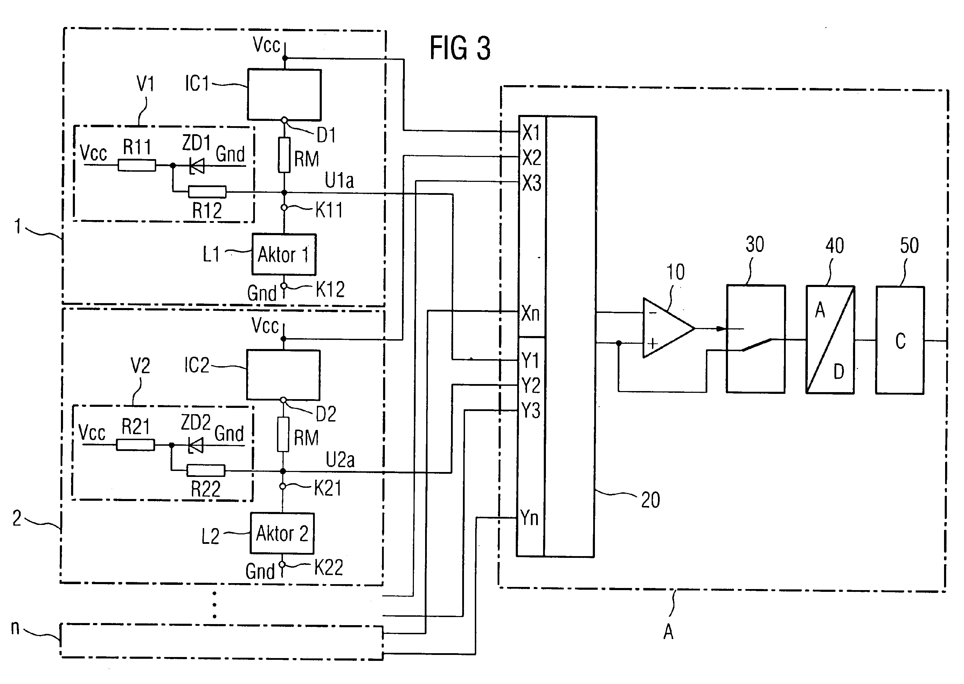

Figur 3 zeigt ein weiteres Ausführungsbeispiel einer möglichen Schaltungsanordnung zum Durchführen des erfindungsgemäßen Verfahrens, bei dem insbesondere eine Vielzahl von digitalen Ausgängen von einer einzigen gemeinsamen Auswertebaugruppe A überwacht werden können. Die Auswertebaugruppe A besteht hier aus einem integrierten Differenz-Multiplexer 20 mit nachgeschaltetem Operationsverstärker 10, elektrischem Wechselschalter 30, Analog-Digital-Wandler 40 und Controller 50. Die an den einzelnen elektrischen Anschlüssen K11, K21, ... der n Steuerbaugruppen anliegenden Spannungswerte U1a, U2a, ... werden vom Differenz-Multiplexer 20 an dessen Eingängen 41, 42, ..., 4n eingelesen. Zur Überprüfung der möglichen Fehlerfälle im Zustand "digital Null" ist der Operationsverstärker 10, so wie in der Figur dargestellt durch den nachfolgenden elektrischen Wechselschalter 30 überbrückt, so dass die eingelesenen Spannungswerte U1a, U2a, ... vom Differenz-Multiplexer 20 direkt über den Analog-Digital-Wandler an einen nachfolgenden Controller zur Auswertung weitergegeben werden können. In diesem Controller werden dann die Spannungswerte mit dort gespeicherten Referenzspannungswerten verglichen und entsprechend, wie bei den in Figur 1 und 2 gezeigten Ausführungsbeispielen, ein Ausgangssignal erzeugt, das einen Fehlerzustand signalisiert. Befindet sich der elektrische Wechselschalter 30 in der anderen, nicht gezeigten, Stellung, so können, wie in Figur 2 gezeigt, mittels dem Operationsverstärker 10 auch Fehlerzustände bei "digital Eins" des Ausgangs der Steuerbaugruppen IC1, IC2 erkannt werden. Diese Schaltungsanordnung bietet insbesondere bei der Fehlerdiagnose bei einer Vielzahl n von digitalen Ausgängen D1,D2,... den Vorteil, dass mit geringstem Aufwand eine Fehlerdiagnose bei allen digitalen Ausgängen D1, D2, ... vorgenommen werden kann. Dabei können die zu überwachenden digitalen Ausgänge alle von einer einzigen Steuerbaugruppe sein oder so wie in Figur 3 dargestellt von n Steuerbaugruppen. Zudem ist es möglich, dass die digitalen Ausgänge D1, D2, ... den gleichen Ausgabewert oder auch unterschiedliche Ausgabewerte aufweisen oder das die angeschlossenen Aktoren L1,L2,... unterschiedliche Spezifikationen aufweisen. Somit zeichnet sich diese Schaltungsanordnung insbesondere durch den geringen Bauteilaufwand und die hohe Flexibilität bei der Überwachung von einer Vielzahl n von digitalen Ausgängen aus.

## Patentansprüche

1. Vorrichtung zur Fehlerdiagnose an digitalen Ausgängen (D1,D2) einer Steuerbaugruppe (IC1,IC2), insbesondere der Erkennung eines Drahtbruchs zwischen einem elektrischen Anschluss (K11,K12,K21,K22) an einem der digitalen Ausgänge (D1,D2) der Steuerbaugruppe (IC1,IC2) und einer an dem elektrischen Anschluss (K11,K12,K21,K22) anschließbaren Last (L1,L2),
**gekennzeichnet durch**
eine Spannungsbegrenzerbaugruppe (V1,V2) und eine Auswertebaugruppe (A), die so mit dem elektrischen Anschluss (K11,K21) verbunden sind, dass bei Drahtbruch zwischen dem elektrischen Anschluss (K11,K12,K21,K22) und der Last (L,L1,L2), an der Auswertebaugruppe (A) ein von der Spannungsbegrenzerbaugruppe (V1,V2) mitbestimmter Spannungswert (U1a) anliegt, wenn der digitale Ausgang (D1,D2) einen ersten Zustand "digital Null" aufweist.

2. Vorrichtung nach Anspruch 1,
**dadurch gekennzeichnet, dass**
der Spannungswert (U1a) durch eine Zenerdiode (ZD1,ZD2), einen ersten Widerstand (R11,R21) und einen zweiten Widerstand (R12,R22) der Spannungsbegrenzerbaugruppe (V1,V2) bestimmt ist.

3. Vorrichtung nach Anspruch 1 oder 2,
**dadurch gekennzeichnet, dass**
die Zenerdiode (ZD1,ZD2), der erste (R11,R21) und der zweite (R12,R22) Widerstand in Abhängigkeit von der Last (L,L1,L2) dimensioniert sind.

4. Vorrichtung nach einem der Ansprüche 1 bis 3,
**dadurch gekennzeichnet, dass**
die Auswertebaugruppe (A) einen ersten Komparator (M1) aufweist, der den ersten Spannungswert (U1a) mit einem ersten Referenzspannungswert (U1ref1) vergleicht und feststellt, ob der erste Spannungswert (U1a) größer als der erste Referenzspannungswert (U1ref1) ist.

5. Vorrichtung nach Anspruch 4,
**dadurch gekennzeichnet, dass**
die Auswertebaugruppe (A) einen zweiten Komparator (M2) mit einem zweiten Referenzspannungswert (U1ref2) und einen dritten Komparator (M3) mit einem dritten Referenzspannungswert (U1ref3) umfasst.

6. Vorrichtung nach einem der Ansprüche 1 bis 3,
**dadurch gekennzeichnet, dass**
die Auswerteeinheit (A) einen Differenz-Multiplexer (20), einen Operationsverstärker 10, einen elektrischen Wechselschalter 30, einen Analog-Digital-Wandler 40 und einen Controller 50 umfasst.

7. Vorrichtung nach Anspruch 6,
**dadurch gekennzeichnet, dass**
einem digitalen Ausgang (D1,D2,...) jeweils eine Spannungsbegrenzerbaugruppe (V1,V2,...) und die gemeinsame Auswerteeinheit (A) gemeinsam zugeordnet ist.

8. Verfahren zur Fehlerdiagnose an digitalen Ausgängen (D1,D2,...) einer Steuerbaugruppe (IC), insbesondere der Erkennung eines Drahtbruchs zwischen einem elektrischen Anschluss (K11,K21,...) an einem der digitalen Ausgänge (D1,D2,...) der Steuerbaugruppe (IC1,IC2,...) und einer an dem elektrischen Anschluss (K11,K21,...) angeschlossenen Last (L,L1,L2,...),
**dadurch gekennzeichnet, dass**
eine Spannungsbegrenzerbaugruppe (V1,V2,...) und eine Auswertebaugruppe (A) so mit dem elektrischen Anschluss (K11,K21,...) verbunden sind, dass bei Drahtbruch zwischen dem elektrischen Anschluss (K1,K11,K21,...) und der Last (L,L1,L2,...), an der Auswertebaugruppe (A) ein von der Spannungsbegrenzerbaugruppe (V1,V2,...) mitbestimmter Spannungswert (U1a,,U2a,...) anliegt, wenn der digitale Ausgang (D1,D2,...) einen ersten Zustand "digital Null" aufweist, und in der Auswerteeinheit (A) dieser erste Spannungswert (U1a,U2a,...) mit einem ersten Referenzspannungswert (U1ref1,U2ref1,) verglichen wird und Drahtbruch erkannt wird, wenn dieser Spannungswert (U1a,U2a,...) größer als der erste Referenzspannungswert (U1ref1,U2ref1,...) ist.
